# EUROPÄISCHE PATENTSCHRIFT

(11) **EP 0 958 620 B1**
(45) Veröffentlichungstag und Bekanntmachung des Hinweises auf die Patenterteilung: **07.05.2003**
(21) Anmeldenummer: 97948725.3
(22) Anmeldetag: 06.11.1997
(51) Int. Cl.: H01L 41/083

(54) **PIEZOAKTOR MIT NEUARTIGER KONTAKTIERUNG UND HERSTELLVERFAHREN**
PIEZO ELECTRIC ACTUATOR WITH A NEW TYPE OF CONTACTING AND A METHOD FOR THE PRODUCTION THEREOF
ACTIONNEUR PIEZO-ELECTRIQUE AVEC MISE EN CONTACT D'UN TYPE NOUVEAU ET PROCEDE DE FABRICATION DUDIT ACTIONNEUR

(30) Priorität: 12.11.1996 DE 19646676
(43) Veröffentlichungstag der Anmeldung: 24.11.1999
(73) Patentinhaber: EPCOS AG, 81541 München (DE)
(72) Erfinder: CRAMER, Dieter, D-83607 Holzkirchen (DE); HELLEBRAND, Hans, D-81669 München (DE); LUBITZ, Karl, D-85521 Ottobrunn (DE); WOLFF, Andreas, D-81739 München (DE); HAMANN, Christoph, D-85551 Kirchheim (DE); SCHERER, Clemens, D-82205 Gilching (DE)
(74) Vertreter: Epping, Wilhelm, Dipl.-Ing.
(86) Internationale Anmeldenummer: DE9702587
(87) Internationale Veröffentlichungsnummer: WO98020721

(56) Entgegenhaltungen:
- EP-A- 0 584 842

## Beschreibung

Piezoaktoren bestehen üblicherweise aus mehreren in einem Stapel angeordneten Piezoelementen. Jedes dieser Elemente wiederum besteht aus einer Piezokeramikschicht, die beiderseits mit metallischen Elektroden versehen ist. Wird an diese Elektroden eine Spannung angelegt, so reagiert die Piezokeramikschicht mit einer Gitterverzerrung, die entlang einer Hauptachse zu einer nutzbaren Längenausdehnung führt. Da diese wiederum weniger als zwei Promille der Schichtdicke entlang der Hauptachse beträgt, muß zur Erzielung einer gewünschten absoluten Längenausdehnung eine entsprechend höhere Schichtdicke aktiver Piezokeramik bereitgestellt werden. Mit zunehmender Schichtdicke der Piezokeramikschicht innerhalb eines Piezoelementes steigt jedoch auch die zum Ansprechen des Piezoelementes erforderliche Spannung. Um diese in handhabbaren Grenzen zu erhalten, werden Mehrschichtaktoren hergestellt, bei denen die Dicken von Piezoeinzelelementen üblicherweise zwischen 20 und 200 µm liegen. Ein Piezoaktor muß für eine gewünschte Längenausdehnung dann eine entsprechende Anzahl an Einzelelementen bzw. -schichten aufweisen.

Bekannte Piezoaktoren in Vielschichtbauweise bestehen daher aus insgesamt bis zu einigen hundert Einzelschichten. Zu deren Herstellung werden Piezokeramikgrünfolien alternierend mit Elektrodenmaterial zu einem Stapel angeordnet und gemeinsam zu einem monolithischen Verbund von bis zu ca. 5 mm Höhe laminiert und gesintert. Größere Aktoren mit größerer absoluter Auslenkung können beispielsweise durch Verkleben mehrerer solcher Stapel erhalten werden. Ausreichend hohe Steifigkeiten, insbesondere wenn mit dem Piezoaktor hohe Kräfte übertragen werden müssen, besitzen Piezoaktoren in voll monolithischer Vielschichtbauweise, die einen ausreichend festen Verbund der Einzelschichten im Stapel zeigen.

Zur elektrischen Kontaktierung solcher Piezoaktoren in Vielschichtbauweise werden beispielsweise Metallisierungsstreifen an der Außenseite des Piezoaktors (wie z.B. aus EP 0 584 842 A bekannt) oder auch in einer Bohrung in der Flächenmitte der Einzelaktoren angebracht. Damit eine Elektrodenschicht für die beiden benachbarten Piezokeramikschichten als Elektrode dienen kann, erfolgt die elektrische Kontaktierung der Elektrodenschichten innerhalb des Stapels in alternierender Polarität. Um beispielsweise jede zweite Elektrodenschicht mit einem der Metallisierungsstreifen zu verbinden, muß dieser gegen die dazwischenliegenden Elektrodenschichten isoliert werden. Dies gelingt in einfacher Weise dadurch, daß jede zweite Elektrodenschicht im Bereich des einen Metallisierungsstreifens eine Aussparung aufweist, in der sie nicht bis zum Metallisierungsstreifen geführt wird. Die übrigen Elektrodenschichten weisen die Aussparungen dann im Bereich des zweiten Metallisierungsstreifens auf, um eine Kontaktierung mit alternierender Polarität zu ermöglichen.

Eine weitere Möglichkeit der alternierenden Kontaktierung besteht darin, jede zweite Elektrodenschicht nachträglich im Bereich der Metallisierungsstreifen zu isolieren. Dies gelingt beispielsweise durch Glasisolierungen, die nach dem Herstellen des gestapelten monolithischen Piezoaktors zum Beispiel elektrophoretisch am Rand der Elektrodenschichten aufgebracht werden. Dieses Verfahren ist jedoch kostenaufwendig und ist auf Piezoaktoren beschränkt, deren keramische Einzelschichten eine Dicke von zumindest 100 µm aufweisen. Wegen der geringen Glasisolierstrecke sind derartig kontaktierte Piezoaktoren außerdem nicht für hohe Zuverlässigkeit und ungeschützte Umgebungsbedingungen geeignet.

Piezoaktoren, deren alternierende Kontaktierung über Aussparungen der Elektrodenschichten erfolgt, sind im Kontaktierungsbereich piezoelektrisch inaktiv, da sich dort durch die jeweils eine fehlende Elektrode kein elektrisches Feld aufbauen kann. Dies hat sowohl bei der Polarisation als auch beim Betrieb des Piezoaktors zur Folge, daß sich in diesem piezoelektrisch inaktiven Kontaktierungsbereich mechanische Spannungen aufbauen, die zu Rissen an den Metallisierungsstreifen parallel zu den Elektrodenschichten führen können. Dies kann zum vollständigen Durchtrennen der Metallisierungsstreifen führen und hat zur Folge, daß bei punktförmiger Spannungszuführung von außen an die Metallisierungsstreifen ein Teil des Piezoaktors von der Spannungsversorgung abgehängt und damit inaktiv wird. Die Zahl der Risse hängt von der Gesamthöhe des Aktors sowie von der Festigkeit der Grenzfläche Innenelektrode/Piezokeramik ab und kann sich auch im Dauerbetrieb bei wechselnden Lastbedingungen weiter erhöhen. Eine bereits bei der Polarisierung bestehende Rißöffnung wird parallel zur Ansteuerung des Aktors weiter vergrößert, geht aber bei Abschalten der Spannung wieder auf den Ausgangswert zurück. Es wird also beim dynamischen Betrieb eine dynamische Veränderung der Risse bzw. eine dynamische Veränderung der Rißöffnungen beobachtet, die die Metallisierungsstreifen weiter schädigen kann.

Aufgabe der vorliegenden Erfindung ist es daher, einen Piezoaktor samt Herstellverfahren anzugeben, der eine sichere elektrische Kontaktierung besitzt, die die negativen Folgen auftretender Spannungsrisse in der Kontaktierung vermeidet.

Diese Aufgabe wird erfindungsgemäß durch einen Piezoaktor nach Anspruch 1 und ein Herstellungsverfahren nach Anspruch 9 gelöst. Vorteilhafte Ausgestaltungen der Erfindung.

Der erfindungsgemäße Piezoaktor kann einen herkömmlichen und vorzugsweise monolithischen Aufbau besitzen. Stapelartig sind alternierend piezoelektrische Keramikschichten und Elektrodenschichten übereinander angeordnet und vorzugsweise zusammen gesintert. Außen am Stapel sind zumindest zwei Metallisierungsstreifen zur alternierenden Kontaktierung der Elektrodenschichten aufgebracht. Erfindungsgemäß sind die Metallisierungsstreifen mit Kontaktfahnen verbunden, die eine elektrisch leitende Schicht aufweisen. Die Verbindung ist elektrisch leitend und erfolgt zumindest über die gesamte Höhe der zu kontaktierenden Elektrodenschichten derart, daß seitlich der Metallisierungsstreifen ein überstehender Bereich der Kontaktfahnen verbleibt.

Vorzugsweise ist die Kontaktfahne dünn, aber reißfest ausgebildet und vorzugsweise auch flexibel.

Die überstehende Kontaktfahne stellt eine elektrisch leitende und mit den Metallisierungsstreifen verbundene, vergrößerte Fläche zur Verfügung, ohne daß dadurch gleichzeitig der inaktive Bereich des Piezoaktors vergrößert werden muß. Treten nun während der Polarisierung oder des Betriebs des Piezoaktors Spannungsrisse im Metallisierungsstreifen auf, so werden diese durch die elektrisch leitende Schicht im überstehenden Bereich der Kontaktfahne überbrückt. Die Breite der Kontaktfahnen und damit die Breite des überstehenden Bereichs ist so bemessen, daß Risse in den Metallisierungsstreifen mit großen Rißöffnungen zwar zu einem lokalen Riß auch in der Kontaktfahne führen, dieser mit Sicherheit jedoch noch innerhalb der Kontaktfahne zum Stehen kommt. Auf diese Weise können sämtliche auftretenden Risse innerhalb der Metallisierungsstreifen elektrisch leitend überbrückt werden, so daß alle ursprünglich kontaktierten Elektrodenschichten elektrisch angeschlossen bleiben und der gesamte Aktor somit keine Leistungseinbuße zeigt.

Mit der Erfindung ist es auch möglich, die Anzahl der Schichten und damit die Stapelhöhe des Piezoaktors zu erhöhen, ohne daß die gleichzeitig damit steigende Gefahr der Rißbildung zum Unterbrechen der elektrischen Kontaktierung und damit zu einer Beeinträchtigung der.Funktionstüchtigkeit des Piezoaktors führt. Es ist also möglich, monolithische Piezoaktoren in Vielschichtbauweise mit größerer Stapelhöhe und damit größerer nutzbarer Auslenkung zu erzeugen. Während große Auslenkungen bisher nur durch Zusammenkleben mehrerer kleinerer monolithischer Aktoren erhalten werden können, läßt sich nun auch die Ausdehnung einzelner monolithischer Piezoaktoren steigern, ohne Beschädigungen der Aktoren in Kauf nehmen zu müssen. Nur monolithische Piezoaktoren besitzen die hohen Steifigkeiten, mit denen hohe Kräfte im dynamischen Betrieb sicher übertragen werden können.

In einer vorteilhaften Ausgestaltung der Erfindung besteht die Kontaktfahne aus einem Verbundmaterial, welches neben der elektrisch leitenden Schicht noch zumindest eine Kunststoffschicht umfaßt. Diese Kunststoffschicht erhöht die Reißfestigkeit der Kontaktfahne und dient zum verbesserten Schutz der Kontaktfahne gegen ein Weiterreißen im Betrieb des Piezoaktors. Eine Kontaktfahne aus Verbundmaterial hat außerdem den Vorteil, daß sie gegenüber einer zum Beispiel rein metallisch ausgebildeten Kontaktfahne, beispielsweise eine Metallfolie, leichter sein kann. Im dynamischen Betrieb des Piezoaktors stellt sie also keinen nennenswerten zusätzlichen mechanischen Ballast dar. Die Kontaktfahne ist mechanisch flexibel und kann somit an verschiedene Einbauarten des Piezoaktors und beispielsweise an verschiedene Einbaugehäuse leicht angepaßt werden. Gegenüber herkömmlichen Kontaktierungen treten nur geringe zusätzliche Materialkosten auf.

In einer weiteren Ausgestaltung der Erfindung umfaßt die Kontaktfahne eine metallisch beschichtete Kunststoffolie. Vorzugsweise ist die metallische, elektrisch leitende Schicht im überstehenden Bereich der Kontaktfahne zusätzlich mit einer weiteren Kunststoffschicht kaschiert. Dies hat den Vorteil, daß die Kontaktfahne im überstehenden Bereich allseitig elektrisch isoliert ist, so daß selbst bei starkem Umbiegen im überstehenden Bereich kein Kurzschluß mit den am Rand des Piezoaktors frei zugänglichen Elektrodenschichten auftreten kann. Durch die beidseits der elektrisch leitenden und zum Beispiel metallischen Schicht aufgebrachten Kunststoffschichten wird die Reißfestigkeit der Kontaktfahne zusätzlich erhöht.

Im Verfahren zum Herstellen eines erfindungsgemäßen Piezoaktors wird ein monolithischer Vielschichtverbund in herkömmlicher und an sich bekannter Weise hergestellt. Dazu können mit Elektrodenmaterial bedruckte Grünfolien übereinander gestapelt und frei oder unter Druck gemeinsam gesintert werden. Die Piezokeramikfolien und gegebenenfalls auch die fertigen Piezoaktoren können einen runden, rechteckigen oder beliebig anderen geformten Querschnitt aufweisen. Das Elektrodenmaterial wird so auf die Folie gedruckt, daß nach dem Stapeln nur jede zweite Elektrodenschicht im Kontaktierungsbereich bis an die Außenkante der piezokeramischen Folie bzw. des späteren Stapels geleitet wird. Durch Aufbringen von je einem Metallisierungsstreifen auf die zwei Kontaktierungsbereiche wird beispielsweise jede zweite Elektrodenschicht mit dem einem, die restlichen Elektrodenschichten mit dem zweiten Metallisierungsstreifen verbunden. Der Metallisierungsstreifen umfaßt ein Metall, das aufgedampft oder aufgesputtert ist oder mit Hilfe einer metallhaltigen Paste aufgebracht und eingebrannt ist.

Auf die Metallisierungsstreifen wird nun eine Kontaktfahne so aufgebracht, daß deren elektrisch leitende Schicht über die gesamte Stapelhöhe der kontaktierten Elektrodenschichten elektrisch leitend und fest verbunden ist. Die elektrisch leitende Verbindung kann mit Hilfe eines Leitklebers, eines Lötvorgangs oder gegebenenfalls gleichzeitig mit dem Einbrennen der Metallisierungsstreifen erfolgen. Vorzugsweise wird die Kontaktfahne aufgelötet. Ein besonders schonendes Lötverfahren ist das Laserstrahllöten. Dieses ermöglicht die selektive Einkopplung der zum Löten erforderlichen Energie in die Kontaktfahne, wobei der Piezoaktor selbst einer nur minimalen thermischen Belastung ausgesetzt wird. Er muß auch nicht vorgewärmt werden, so daß keine Schädigung der Keramik durch Thermoschock oder Überhitzen eintreten kann.

Das für die Lötung erforderliche Lot ist vorzugsweise bereits auf der Kontaktfahne aufgebracht. Dazu wird es in dem zur Verlötung vorgesehenen Bereich in herkömmlicher Weise, beispielsweise durch Bedampfen, Sputtern oder Galvanisieren mit einem passenden Lötzinn herkömmlicher Zusammensetzung beschichtet.

Zum Aufbringen der Kontaktfahne mittels Laserstrahllötens ist es von Vorteil, wenn die Kontaktfahne ein Verbundmaterial aus einem Kunststoff und einer elektrisch leitenden Schicht umfaßt, deren Kunststoff für die Wellenlänge des zum Löten verwendeten Lasers transparent ist. Auf diese Weise kann die Laserenergie nahezu vollständig in die elektrisch leitende Schicht bzw. das darüber aufgebrachte Lötzinn eingekoppelt werden.

Die Verlötung der Metallisierungsstreifen mit der Kontaktfahne erfolgt durchgehend über die gesamte Länge des Metallisierungsstreifens oder zumindest über die gesamte Stapelhöhe der zu kontaktierenden Elektrodenschichten. Dazu kann ein Dauerstrichlaser oder ein entsprechend gerasteter gepulster Laser verwendet werden. Die Dauer der Laserlötung beträgt typischerweise nur wenige Sekunden und läßt sich automatisiert durchführen.

Im folgenden wird die Erfindung anhand eines Ausführungsbeispiels und der dazugehörigen sechs Figuren näher erläutert.
- Figur 1: zeigt die Kontaktierung eines Piezoaktors in schematischer Querschnittsdarstellung.
- Figur 2: zeigt einen erfindungsgemäßen Piezoaktor im schematischen Querschnitt.
- Figur 3: zeigt einen erfindungsgemäßen Piezoaktor in perspektivischer schematischer Darstellung und
- Figuren 4 bis 6: zeigen mögliche Ausgestaltungen einer Kontaktfahne im schematischen Querschnitt.

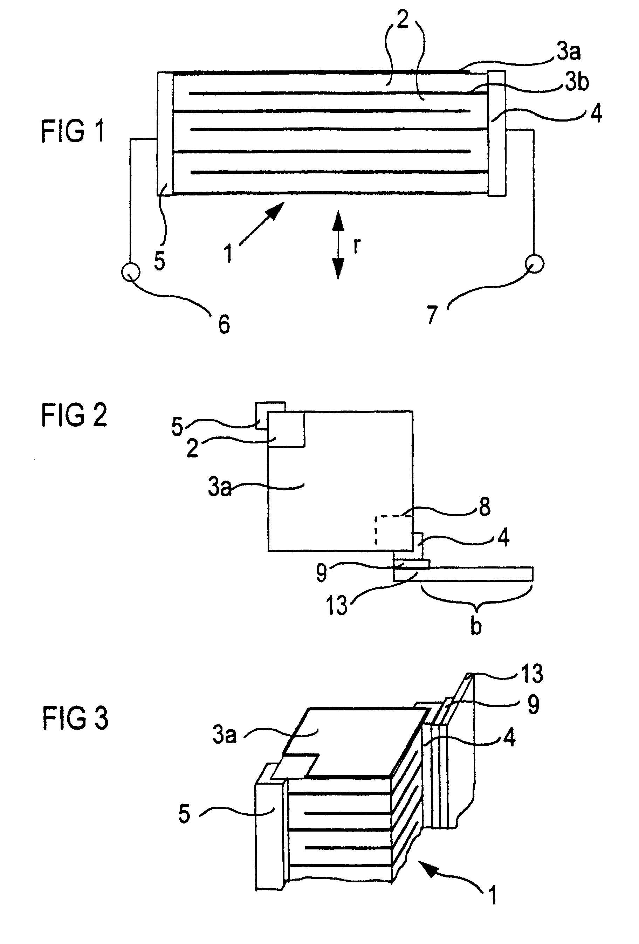

Figur 1 zeigt einen an sich bekannten Piezoaktor in Vielschichtbauweise ausschnittsweise in schematischer Darstellung. Dieser besteht aus einem Stapel von Piezokeramikschichten 2 und dazwischen angeordneten Elektrodenschichten 3. Als Piezokeramik kann eine beliebige PZT-Keramik (= Bleizirkonattitanat) eingesetzt werden. Die Elektrodenschichten sind aus einem geeigneten Material, vorzugsweise einer silberhaltigen Einbrennpaste. Die Elektrodenschichten können noch zusätzliche oxidische Zuschläge zur besseren Haftung auf den Piezokeramikschichten 2 sowie andere Metalle allein oder als weiteren Zusatz enthalten, beispielsweise Platin oder Palladium.

Der hier mit sechs Piezokeramikschichten 2 dargestellte Stapel wird durch gemeinsames Sintern, gegebenenfalls unter erhöhtem Druck, zu einem festen Verbund vereinigt. Am Rand des Stapels, parallel zur Stapelrichtung sind Metallisierungsstreifen 4 und 5 angebracht. Diese können ebenfalls aus einer eingebrannten Silberpaste bestehen, können alternativ aber auch aufgedampft oder aufgesputtert sein. Maßgeblich ist jedoch weder die Art des Metalles noch die Art der Aufbringung der Metallisierungsstreifen am Piezoaktorstapel. An jedem Metallisierungsstreifen 4, 5 wiederum werden nun die elektrischen Anschlüsse 6 und 7 befestigt, beispielsweise durch Auflöten eines elektrischen Leiters. Die Verbindung kann dabei an einem oder an mehreren Punkten eines Metallisierungsstreifens oder der Kontaktfahne hergestellt werden. Nach der Polung parallel zur Stapelrichtung wird ein funktionsfähiger Piezoaktor erhalten, der bei Anlegen einer Spannung an die Anschlüsse 6 und 7 eine Auslenkung in Richtung r zeigt. Monolithische Aktoren zur Übertragung großer Kräfte können Stapelhöhen bis zu 40 mm erreichen und je nach Dicke der Piezokeramikschichten bis zu 1000 Keramikschichten 2 umfassen.

Desweiteren geht aus der Figur 1 hervor, wie die einzelnen Elektrodenschichten parallel so verschaltet werden, daß jede zweite Elektrodenschicht auf gleicher Polarität liegt. Dazu werden die Elektrodenschichten 3 so auf den Piezokeramikschichten 2 aufgebracht, daß Aussparungen 14 im Kontaktierungsbereich bei den Metallisierungsstreifen verbleiben, die nicht mit Elektrodenmaterial bedeckt sind. Diese Aussparungen dienen zur Isolation der Elektrodenschicht gegenüber dem Metallisierungsstreifen, an den sie nicht angeschlossen werden soll.

Figur 2 zeigt einen beispielhaften Piezoaktor im Querschnitt durch die Ebene einer Innenelektrode. In der Figur ist der Aktor mit quadratischem Grundriß dargestellt, kann jedoch auch beliebige andere Formen aufweisen. Die oberste Elektrodenschicht 3a hat in der linken oberen Ecke eine Aussparung, an der die darunterliegende Piezokeramikschicht 2 sichtbar ist. Diese Aussparung kann nicht nur quadratisch, wie bezeichnet, sondern auch rechteckige oder elliptische oder kreisförmige Abmessung besitzen und nicht nur an der Ecke, sondern auch in der Mitte der Aktorseite angeordnet sein. Die Elektrodenschicht 3a ist elektrisch leitend mit dem Metallisierungsstreifen 4 verbunden, der hier an der Ecke aufgebracht ist. Der an der gegenüberliegenden Ecke aufgebrachte Metallisierungsstreifen 5 besitzt aufgrund der Aussparung in der Elektrodenschicht 3a keinen Kontakt mit dieser. Er ist dagegen mit der darunterliegenden (hier nicht sichtbaren) Elektrodenschicht 3b verbunden, die an der gegenüberliegenden Ecke des Aktors die gestrichelt dargestellte und mit 8 bezeichnete Aussparung aufweist.

Erfindungsgemäß werden nun die Metallisierungsstreifen 4 und 5 mit einer Kontaktfahne 13 verbunden. Die Verbindung erfolgt über die gesamte Höhe des Stapels oder zumindest über die gesamte Höhe der zu kontaktierenden Elektrodenschichten 3. Die Kontaktfahne 13 wird mit Hilfe eines Verbindungsmittels 9 aufgebracht, beispielsweise eines leitfähigen Klebers oder einer Lotschicht. Gegenüber dem Stapel bzw. der Verbindung mit dem Metallisierungsstreifen 4 weist die Kontaktfahne 13 einen überstehenden Bereich auf, dessen Länge b ausreichend ist, daß während des Betriebs oder der Polung des Piezoaktors 1 auftretende Risse im Metallisierungsstreifen innerhalb der Kontaktfahne 13 auslaufen. Für beispielhafte Piezoaktoren mit einer Grundfläche von 7 x 7 mm und einer Höhe von bis zu 40 mm ist es ausreichend, wenn der überstehende Bereich eine Breite b von 5 bis 10 mm besitzt. Bei geringeren Stapelhöhen kann die Breite des überstehenden Bereichs b auch kleiner gewählt werden.

Am Ende des überstehenden Bereichs b kann dann die Weiterkontaktierung in beliebiger Weise, zum Beispiel durch Anlöten eines Drahts, zur Weiterführung an die elektrischen Anschlüsse 6 und 7 erfolgen.

In gleicher Weise wird der zweite Metallisierungsstreifen 5 mit einer gleichartigen Kontaktfahne 13 verbunden. Als bevorzugtes Aufbringverfahren wird Laserstrahllöten verwendet.

Figur 3 zeigt ausschnittsweise und in perspektivischer schematischer Darstellung einen Piezoaktor 1 mit einer angebrachten Kontaktfahne 13. Der dargestellte Piezoaktor zeigt zwar eine Längenausdehnung, ist jedoch noch nicht zur Übertragung großer Kräfte geeignet. Dazu sind hier nicht dargestellte piezoelektrisch inaktive Stirnplatten auf Ober- und Unterseite des Piezoaktors 1 erforderlich, die ebenfalls monolithisch mit dem Stapel verbunden sind.

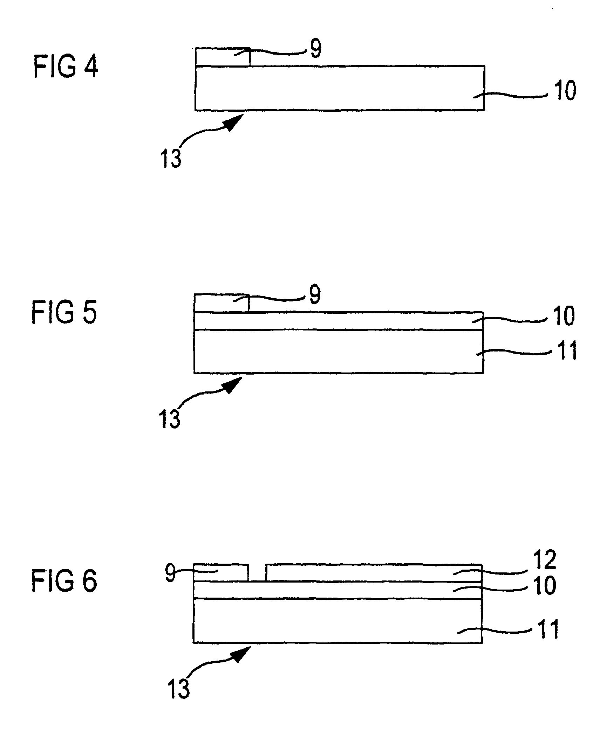

Figur 4 zeigt die einfachste Ausführungsform einer Kontaktfahne im schematischen Querschnitt, bei der die Kontaktfahne nur eine elektrisch leitfähige Schicht umfaßt, beispielsweise eine Metallfolie 10. Wahlweise kann die elektrisch leitende Schicht (Folie) 10 entlang einer Kante bereits mit Lot 9 oder einem anderen elektrisch leitfähigen Verbindungsmittel beschichtet sein, das zum Verbinden mit den Metallisierungsstreifen 4 und 5 dient. Die Länge der Kontaktfahne vertikal zur dargestellten Schnittebene entspricht beispielsweise der Stapelhöhe des Piezoaktors 1, während die Breite der Kontaktfahne 13 bzw. der Folie 10 zumindest der Breite b des überstehenden Bereichs plus der Breite der Verbindung mit den Metallisierungsstreifen entspricht. Für die beispielhaft genannten Piezoaktoren von 7 x 7 x 40 (mm)³ ist ein überstehender Bereich b von 5 bis 10 mm ausreichend.

Figur 5 zeigt eine weitere Ausführung der Kontaktfahne 13, bei der diese ein Verbundmaterial aus einem Träger 11 und einer elektrisch leitenden Schicht 10 umfaßt. Als Träger 11 wird beispielsweise eine Kunststoffolie verwendet, die mit einem elektrisch gut leitfähigen Metall 10 beschichtet ist. In einer Ausführungsform der Erfindung wird als Träger 11 eine Kaptonfolie ® von beispielsweise 25 µm Dicke verwendet, die mit einem geeigneten Metall, beispielsweise mit 25 µm Kupfer, beschichtet ist. Als Verbindungsmittel 9 wird beispielsweise galvanisch eine Zinnschicht 9 aufgebracht. Die Verwendung von Kupfer für die elektrisch leitfähige Schicht 10 hat den Vorteil einer guten Lötbarkeit sowie einer hohen elektrischen Leitfähigkeit.

Figur 6 : In einer weiteren Ausgestaltung der Erfindung ist die Kontaktfahne 13 ähnlich wie in Figur 5 ausgebildet, weist jedoch noch neben dem Lotstreifen 9 noch eine Isolierschicht 12 auf, mit der nahezu die gesamte Oberfläche der elektrisch leitfähigen Schicht 10 abgedeckt bzw. kaschiert ist. Diese Isolierschicht 12 kann eine weitere Kunststoffschicht sein, die direkt an den Lotstreifen 9 grenzt, oder wie dargestellt, von diesem beabstandet ist.

Wird als Aufbringverfahren ein Laserstrahllöten verwendet, so ist es besonders vorteilhaft, wenn die Kontaktfahnen gemäß den Figuren 5 und 6 einen für die Wellenlänge des verwendeten Lasers transparenten Träger 11 umfassen, beispielsweise die genannte Kaptonfolie. Auf diese Weise kann das Laserstrahllöten mit geringstem Energieaufwand durchgeführt werden, wobei die Laserenergie nahezu vollständig in das aufzuschmelzende Lot 9 eingekoppelt werden kann. Eine thermische Belastung der Folie 11 oder des Piezoaktors 1 wird dabei vermieden.

## Patentansprüche

1. Piezoaktor in Vielschichtbauweise mit den folgenden Merkmalen
- piezoelektrische Keramikschichten (2) und Elektrodenschichten (3) sind alternierend übereinander zu einem Stapel (1) angeordnet
- die Elektrodenschichten (3) sind zur elektrischen Kontaktierung in alternierender Polarität abwechselnd mit zumindest zwei seitlich am Stapel aufgebrachten Metallisierungsstreifen (4, 5) verbunden, **gekennzeichnet durch**
- Kontaktfahnen (13), die eine elektrisch leitende Schicht (10) aufweisen, über diese elektrisch leitende Schicht mit den Metallisierungsstreifen (4, 5) zumindest über die gesamte Höhe der kontaktierten Elektrodenschichten (3) so verbunden sind, daß seitlich der Metallisierungsstreifen ein überstehender Bereich (b) der Kontaktfahnen verbleibt.

2. Piezoaktor nach Anspruch 1,
der monolithisch aufgebaut ist.

3. Piezoaktor nach Anspruch 1 oder 2,
bei dem die Kontaktfahne (13) ein Verbundmaterial aus einer elektrisch leitenden Schicht (10) und einer Kunststoffschicht (11) ist.

4. Piezoaktor nach Anspruch 3,
bei dem die Kontaktfahne (13) eine metallisch beschichtete Kunststoffolie (11) ist.

5. Piezoaktor nach einem der Ansprüche 1 bis 4
bei dem der überstehende Bereich (b) der Kontaktfahne (13) eine Breite von zumindest 5 bis 10mm besitzt.

6. Piezoaktor nach einem der Ansprüche 1 bis 5,
bei dem die Kontaktfahne (13) eine beidseitig mit Kunststoff (11, 12) kaschierte elektrisch leitende Schicht (10) umfaßt, die im Bereich der Metallisierungsstreifen nur einseitig oder gar nicht mit Kunststoff (12) kaschiert ist.

7. Piezoaktor nach einem der Ansprüche 1 bis 6,
bei dem die Kontaktfahne (13) eine mit Kupfer beschichtete Kunststoffolie (11) umfaßt.

8. Piezoaktor nach einem der Ansprüche 1 bis 7,
bei dem die Metallisierungsstreifen (4, 5) eine Einbrennmetallisierung umfassen.

9. Verfahren zum Kontaktieren eines Piezoaktors in Vielschichtbauweise,
- bei dem piezoelektrische Keramikschichten (2) und Elektrodenschichten (3) alternierend übereinander angeordnet und zu einem monolithischen Verbund (1) verbunden werden,
- bei dem zumindest zwei Metallisierungsstreifen (4, 5) seitlich am Stapel (1) aufgebracht werden, um die Elektrodenschichten (3) in alternierender Polarität elektrisch zu kontaktieren, **dadurch gekennzeichnet, dass**
- die Metallisierungsstreifen (4, 5) über die gesamte Höhe der kontaktierten Elektrodenschichten (3) mit je einer, eine elektrisch leitende Schicht (10) aufweisenden Kontaktfahne (13) über die elektrisch leitende Schicht so verbunden werden, daß seitlich der Metallisierungsstreifen ein überstehender Bereich (b) verbleibt.

10. Verfahren nach Anspruch 9,
bei dem die elektrisch leitende Schicht (10) im zu verbindenden Bereich eine Lotschicht (9) aufweist und die Kontaktfahne (13) dann mit Hilfe dieser Lotschicht und einem Lötverfahren auf die Metallisierungsstreifen (4, 5) aufgelötet wird.

11. Verfahren nach Anspruch 9 oder 10,
bei dem das Verbinden der Metallisierungsstreifen (4, 5) mit den Kontaktfahnen (13) mittels Laserlötens erfolgt.

## Claims

1. Piezoelectric actuator of multilayer design having the following features
- piezoelectric ceramic layers (2) and electrode layers (3) are arranged alternately one above another to form a stack (1)
- the electrode layers (3), for the purpose of making electrical contact, are alternately connected with alternating polarity to at least two metallization strips (4, 5) applied at the side to the stack, **characterized in that**
- contact tabs (13) which have an electrically conductive layer (10) are connected via this electrically conductive layer to the metallization strips (4, 5), at least over the entire height of the contacted electrode layers (3), such that a projecting region (b) of the contact tabs remains at the side of the metallization strips.

2. Piezoelectric actuator according to Claim 1, which is constructed monolithically.

3. Piezoelectric actuator according to Claim 1 or 2, in which the contact tab (13) is a composite material made of an electrically conductive layer (10) and a plastic layer (11).

4. Piezoelectric actuator according to Claim 3, in which the contact tab (13) is a metal-coated plastic film (11).

5. Piezoelectric actuator according to one of Claims 1 to 4, in which the projecting region (b) of the contact tab (13) has a width of at least 5 to 10 mm.

6. Piezoelectric actuator according to one of Claims 1 to 5, in which the contact tab (13) comprises an electrically conductive layer (10) laminated on both sides with plastic (11, 12) and, in the region of the metallization strips, laminated with plastic (12) on only one side or even not at all.

7. Piezoelectric actuator according to one of Claims 1 to 6, in which the contact tab (13) comprises a plastic film (11) coated with copper.

8. Piezoelectric actuator according to one of Claims 1 to 7, in which the metallization strips (4, 5) comprise a baked metallization.

9. Process for making contact with a piezoelectric actuator of multilayer design,
- in which piezoelectric ceramic layers (2) and electrode layers (3) are arranged alternately one above another and connected to form a monolithic composite (1),
- in which at least two metallization strips (4, 5) are applied at the side to the stack (1) in order to make electrical contact with alternating polarity with the electrode layers (3),
**characterized in that**
- the metallization strips (4, 5) are each connected over the entire height of the contacted electrode layers (3) to a contact tab (13) having an electrically conductive layer (10), via the electrically conductive layer, such that a projecting region (b) remains at the side of the metallization strips.

10. Process according to Claim 9, in which the electrically conductive layer (10) has, in the region to be connected, a solder layer (9), and the contact tab (13) is then soldered onto the metallization strips (4, 5) using this solder layer and a soldering process.

11. Process according to Claim 9 or 10, in which the connecting of the metallization strips (4, 5) to the contact tabs (13) is carried out by means of laser soldering.

## Revendications

1. Actionneur piézo-électrique en mode de construction stratifié ayant les caractéristiques suivantes
- des couches (2) piézo-électriques en céramique et des couches (3) d'électrode sont superposées en alternance en une pile (1)
- les couches (3) d'électrode sont, pour la mise en contact électrique, reliées en polarité alternée en alternance avec au moins deux bandes (4, 5) de métallisation déposées latéralement sur la pile, **caractérisé en ce que**
- des oreilles (13) de contact, qui ont une couche (10) conductrice de l'électricité, sont reliées par cette couche conductrice de l'électricité aux bandes (4, 5) de métallisation au moins sur toute la hauteur des couches (3) d'électrode à mettre en contact, de manière à laisser subsister latéralement aux bandes de métallisation une zone (b) des oreilles de contact qui est en saillie.

2. Actionneur piézo-électrique suivant la revendication 1,
qui est de constitution monolithique.

3. Actionneur piézo-électrique suivant la revendication 1 ou 2,
dans lequel l'oreille (13) de contact est un matériau composite constitué d'une couche (10) conductrice de l'électricité et d'une couche (11) en matière plastique.

4. Actionneur piézo-électrique suivant la revendication 3,
dans lequel l'oreille (13) de contact est une feuille (11) en matière plastique revêtue d'un métal.

5. Actionneur piézo-électrique suivant l'une des revendications 1 à 4,
dans lequel la zone (b) de l'oreille (13) de contact qui est en saillie a une largeur d'au moins 5 à 10 mm.

6. Actionneur piézo-électrique suivant l'une des revendications 1 à 5,
dans lequel l'oreille (13) de contact comprend des deux côtés une couche (10) conductrice de l'électricité qui est doublée sur les deux faces de matière plastique (11, 12) et qui, dans la zone des bandes de métallisation, n'est doublée que d'un côté ou n'est pas du tout doublée de matière plastique (12).

7. Actionneur piézo-électrique suivant l'une des revendications 1 à 6,
dans lequel l'oreille (13) de contact comprend une feuille (11) de matière plastique revêtue de cuivre.

8. Actionneur piézo-électrique suivant l'une des revendications 1 à 7,
dans lequel les bandes (4, 5) de métallisation comprennent une métallisation au four.

9. Procédé de mise en contact d'un actionneur piézo-électrique en mode de construction stratifié,
- dans lequel on superpose en alternance des couches (2) piézo-électriques en céramique et des couches (3) d'électrode et on les relie en un composite (1) monolithique,
- dans lequel on dépose au moins deux bandes (4, 5) de métallisation latéralement sur la pile (1) pour mettre électriquement en contact en polarité alternée les couches (3) d'électrode, **caractérisé en ce que**
- on relie par la couche conductrice de l'électricité des bandes (4, 5) de métallisation sur toute la hauteur des couches (3) d'électrode mises en contact à respectivement une oreille (13) de contact ayant une couche (10) conductrice de l'électricité de façon à laisser subsister latéralement aux bandes de métallisation une zone (b) qui est en saillie.

10. Procédé suivant la revendication 9,
dans lequel la couche (10) conductrice de l'électricité a, dans la zone à lier, une couche (9) de brasure et l'oreille (13) de contact est ensuite soudée à l'aide de cette couche de brasure et d'un procédé de brasure sur les bandes (4, 5) de métallisation.

11. Procédé suivant la revendication 9 ou 10,
dans lequel on effectue la liaison des bandes (4, 5) de métallisation aux oreilles (13) de contact au moyen d'une brasure laser.
